# EUROPEAN PATENT SPECIFICATION

(11) **EP 2 701 471 B1**
(45) Date of publication and mention of the grant of the patent: **07.06.2017**
(21) Application number: 13193556.1
(22) Date of filing: 26.04.2011
(51) Int. Cl.: H05K 1/02, H01R 107/00, H01R 13/6461, H01R 13/6476

(54) **High speed input/output connection interface element and interconnection system with reduced cross-talk**
Hochgeschwindigkeits-E/A-Verbindungsschnittstellenelement und Verbindungssystem mit verringertem Übersprechen
Élément d'interface de connexion d'entrée/sortie à grande vitesse et système d'interconnexion doté d'une diaphonie réduite

(43) Date of publication of application: 26.02.2014
(62) Divisional of application: 11163695.7
(73) Proprietor: Tyco Electronics Belgium EC BVBA, 8020 Oostkamp (BE); Tyco Electronics Nederland B.V., 5222 AR'S-Hertogenbosch (NL)
(72) Inventor: Smink, Rutger, 3930 Hamont-Achel (BE); Decrock, Lieven, 8800 Roeselare (BE)
(74) Representative: Grünecker Patent- und Rechtsanwälte PartG mbB

(56) References cited:
- EP-A2- 2 224 552
- GB-A- 1 290 800
- US-A1- 2009 277 665

## Description

The present invention relates to a high speed input/output (I/O) connection interface element, to a cable assembly comprising such an interface element and to an interconnection system comprising such a cable assembly and a belonging jack connector for contacting the cable assembly.

Due to the high data rates in recently developed communication systems having data transmission rates of more than 5 Gbps, cross-talk between signal lines has become a major concern.

Ideally, an interconnection system will carry signals without distortion. One type of distortion is called cross-talk. Cross-talk occurs when one signal creates an unwanted signal on another signal line. Generally, cross-talk is caused by electromagnetic coupling between signal lines. Therefore, cross-talk is a particular problem for high-speed, high-density interconnection systems. Electromagnetic coupling increases when signal lines are closer together or when the signals they carry are higher frequency. Both of these conditions are present in a high-speed, high-density interconnection system. Discontinuities in the connector often exacerbate any cross-talk problems. It is known to insert a shielding into the connectors in the connection system in order to reduce the impact of cross-talk.

Furthermore, it is known to use differential signals for transporting information. One differential signal is carried on two conductors, with the signal being represented as the difference in electrical levels between the conductors. A differential signal is more resistant to cross-talk than a single-ended signal, because any stray signals impinging on the conductors will generally change the level on both conductors, but do not alter the difference in levels.

Consequently, conventional high-speed I/O connection cable assemblies use circuit boards as a substrate to be plugged into a jack connector and cables having a pair of wires for carrying the differential signal. The printed circuit board has traces and pads on at least one of its surfaces, wherein particular contact pads may be contacted by a mating receptacle. The traces transmit electrical signals across the printed circuit board. For example, they may transmit signals from the contacts of the mating receptacle to the wires of the cable assembly and vice versa.

The cable assembly may include several pairs of wires, for example four input signal cables and four output signal cables. However, the cable assembly may also include up to 32 or more pairs of wire, i. e. in general the cable assembly includes wire pairs in increments of two. The cable assembly furthermore includes drain wires which are connected to the shielding of each cable.

The transition from the printed circuit board to the cable within the connector accordingly needs to be capable of handling the high data rates as well. Moreover, due to the small form factor of the connector, the cross-talk between the adjacent pairs of lines is an important parameter. It has been found by the inventors of the present invention that a major contributor to cross-talk is the printed circuit board at the cable connection interface.

In order to reduce cross-talk on the connection interface element, it is known to separate the input and output pairs of wires (Rx and Tx) by routing the input and output pairs on the top and bottom of the printed circuit board, respectively. By employing additional ground layers within the printed circuit board, cross-talk between Rx and Tx lines can be eliminated effectively.

However, at the interface whereto the cable is soldered, impedance compensation has to be used in order avoid distortions of the signal due to signal reflection. Therefore, conventional cable assemblies dispense with internal ground layers in the particular region where the cables are soldered to the conductive pads of the traces. Thereby, however, cross-talk between the signal lines is no longer eliminated effectively enough. In particular, when complying with 10 Gbps specifications, such as IEEE standard 802.3ap 10GBASE-KR (2008), these known geometries do not fulfill the respective requirements to a satisfying extent.

From GB 1 290 800 A a layout for a printed circuit board member is known, which can be inserted into a suitable connector block. The circuit board member has on one face of a sheet of dielectric and on at least one of the marginal portions thereof at least one enlarged connecting pad, which is connected to a respective conductive strip of a printed circuit carried by said one face. A continuous conductive layer, termed "ground plane" is provided for interacting with the conductive strip of the printed circuit forming a two wire transmission line.

US 2009/277665 A1 discloses a connector for balanced transmission which includes a block member having input and output contact pairs formed on front and back surfaces thereof, and a relay wiring substrate having front and back surfaces with a ground layer in between, on which surfaces input contact connecting pads, output contact connecting pads, input wiring patterns, and output wiring patterns are formed. Each input contact pair includes a pair of contact parts formed on the front or back surface of the block member and a pair of lead parts connected to the input contact connecting pads formed on the front or back surface of the relay wiring substrate. Each output contact pair includes a pair of contact parts formed on the front or back surface of the block member and a pair of lead parts connected to the output contact connecting pads formed on the front or back surface of the relay wiring substrate.

The object underlying the present invention therefore is to improve a high-speed input/output connection interface element and a belonging cable assembly with regard to cross-talk reduction, at the same time maintaining the small form factor and the cost-effective construction. This object is solved by the subject matter of the independent claim 1. Advantageous developments of the inventive connection interface element are the subject matter of the dependent claims.

The invention is based on the finding that by providing clearances in a region adjacent to the transition interface between the pads on the substrate and the soldered wires and thereby only leaving narrow strips of the grounding layer in a marginal region of same, lower frequency cross-talk components get blocked. At the same time, the differential impedance at the interface is influenced only to a negligible extent, so that the electrical performance of the transition between the cable and the interface element are maintained.

Although higher frequency components still may contribute to cross-talk, up to 5 GHz (i. e. 10 Gbps), a decrease in cross-talk between opposite Tx and Rx pairs of about 3 dB could be achieved by this arrangement. Thus, a reduced cross-talk and therefore an improved electrical performance of the data link can be achieved with the arrangement according to the present invention.

The present invention may advantageously be employed for all copper cable assembly links, especially those used in high-speed applications, such as the small form factor pluggable (SFP+), the quad small form factor pluggable (QSFP) and the high-speed input/output (HSIO) products of Tyco Electronics Corporation.

The least influence on the impedance matching can be achieved when forming the clearance in a way that in an outer peripheral region of the transition interface, a grounding strip is formed which has in a direction along the conductive leads a dimension of less than 10% of the dimension of the transition interface.

By providing a separate clearance for each pair of leads and by separating these clearances by a web formed of the grounding layer, cross-talk between adjacent pairs of leads can be reduced.

The connection interface element according to the present invention may be formed in a particularly cost-effective way by a multilayer printed circuit board (PCB). Such a PCB may have a trace layer, a core layer, a ground plane layer, a center layer, a further ground layer, a further core layer and a second trace layer. The trace layers and the ground plane layers advantageously are fabricated from a conductive material, such as copper. The core layers and center layer are for instance fabricated from an insulated material, such as a composite of a resin epoxy re-enforced with a woven fiberglass mat, such as FR408. Furthermore, the PCB may also include a solder mask layer, which is located around the trace layers and leaves open only the pad to be soldered and the connection regions to be engaged with the jack connector.

A cable assembly comprising one or more cables and the interface element according to the present invention, advantageously is provided with an electrically insulating housing. Furthermore, an overmold material may be provided for mechanically securing the cable to the interface element.

An interconnection system according to the present invention comprises a plurality of input/output cables, an interface element connected thereto and a jack connector, which is adapted to be detachably connected to contact regions provided at the interface element. In order to allow a secure mechanical contact which nevertheless may be released easily, the jack connector comprises spring contact elements for engaging with the contact regions of the interface element. In order to reduce signal interferences along the cables, same comprise a pair of lines for carrying differential signals representing one input or output signal, and a shielding which is connected to ground by means of drain wires.

The accompanying drawings are incorporated into and form a part of the specification to illustrate several embodiments of the present invention. These drawings together with the description, serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combination-solutions according to the present invention. Further features and advantages will become apparent from the following more particular description of the various embodiments of the invention, as illustrated in the accompanying drawings, in which like references refer to like elements.
- **Fig. 1**: shows a perspective view of a part of a cable assembly according to the present invention;
- **Fig. 2**: shows the layout of a first ground plane layer according to the present invention;
- **Fig. 3**: shows the layout of a first trace layer according to the present invention;
- **Fig. 4**: shows the correlation of the first trace layer and the ground plane layer with respect to each other;
- **Fig. 5**: shows the insertion loss to cross-talk ratio fit depending on the frequency for a conventional cable assembly compared to the requirements of the standard IEEE 802.3ap 10GBASE-KR (2008);
- **Fig. 6**: shows the insertion loss to cross-talk ratio fit for the cable assembly according to the present invention;
- **Fig. 7**: shows a perspective view of a connector jack housing;
- **Fig. 8**: shows a perspective view of an example of a connector jack contact area.

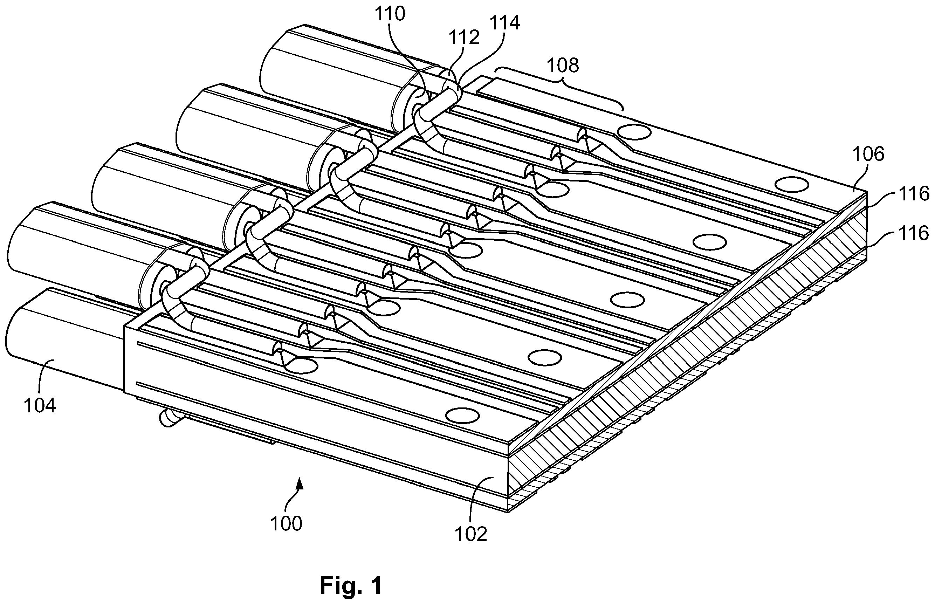

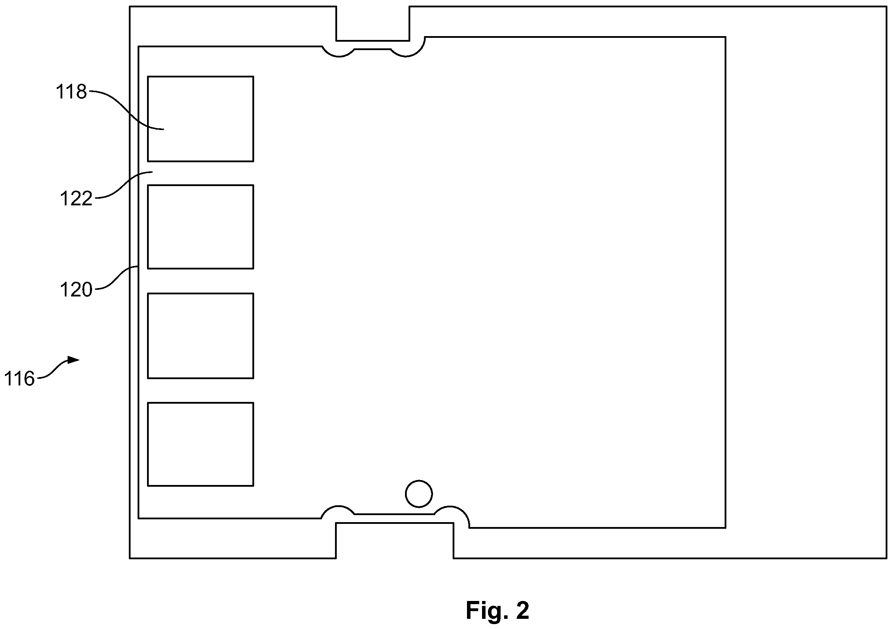

Referring now to FIG. 1, a cable assembly 100 comprises a substrate 102 and a plurality of cables 104 which are soldered to the conductive pads on the traces on the substrate 102. According to the present invention, the substrate 102 has a plurality of traces 106 leading from a transition interface 108 to a plurality of contact regions for engaging with a jack connector. The contact regions are not shown in the cut view of FIG. 1, but will be explained with reference to FIGs 2 to 4 in more detail.

According to the present invention, each cable 104 comprises two wires 110, 112, which together carry a differential signal, as this is generally known. In the region of the I/O transition interface 108, the wires 110, 112 are soldered to the traces 106. Furthermore, drain leads 114, which are connected to a shielding of the cable 104, are connected to a grounded trace, which in turn is connected with vias to all other ground plane layers to form a common ground. However, instead of soldered cables, of course also any other suitable conductor may be attached to the interface element, as well by other connecting technologies, such as crimped connections or plug connections.

According to the present invention, the input (Rx) and the output (Tx) cables are arranged in a way that on one surface of the substrate 102 only the Tx cables and on the other surface of the substrate 102 only the Rx pairs are present. For reducing cross-talk between the upper and lower pairs of cables and traces 106, two ground plane layers 116 are provided within the substrate 102. Of course, also only one ground plane layer or more than two can be used.

As becomes apparent from the layout of the ground plane layer 116, which is shown in FIG 2, the ground plane layer is a solid metal shield in the area where the traces 106 extend over the substrate 102, but has clearances 118 in the transition interface region 108, where the cables are soldered to solder pads of the interface element. The clearances 118 are arranged and dimensioned in a way that directly below each pair of signal trace solder pads, no ground plane metallization is present, whereas in an outer peripheral region narrow grounding strips 120 are formed.

As shown in FIG. 2, each of the clearances 118 is separated from an adjacent one by means of a web shaped part 122 of the ground plane layer 116. These web shaped structures 122 are directly underlying the ground leads of the trace layer 106. By using such a cross-talk suppression strip 120 inside the printed circuit board 102, a two-fold effect can be achieved: Firstly, a part of the ground layer 116 is still underneath the respective traces having an effect equal to an ESD shield. On the other hand, to achieve the necessary impedance match and therefore to avoid signal reflections, a cut-out is present below the traces in a region where the cables are connected in the form of the clearances 118. Therefore, cross-talk components up to at least 5 GHz can be blocked, while still maintaining the unaltered (or only marginally different) differential impedance.

In a region where the connectors to the jack connector are located, according to the present design, the ground plane layer is completely absent. However, for a person skilled in the art it is of course clear that, if necessary, similar structures as in the transition interface region 108 could be applied.

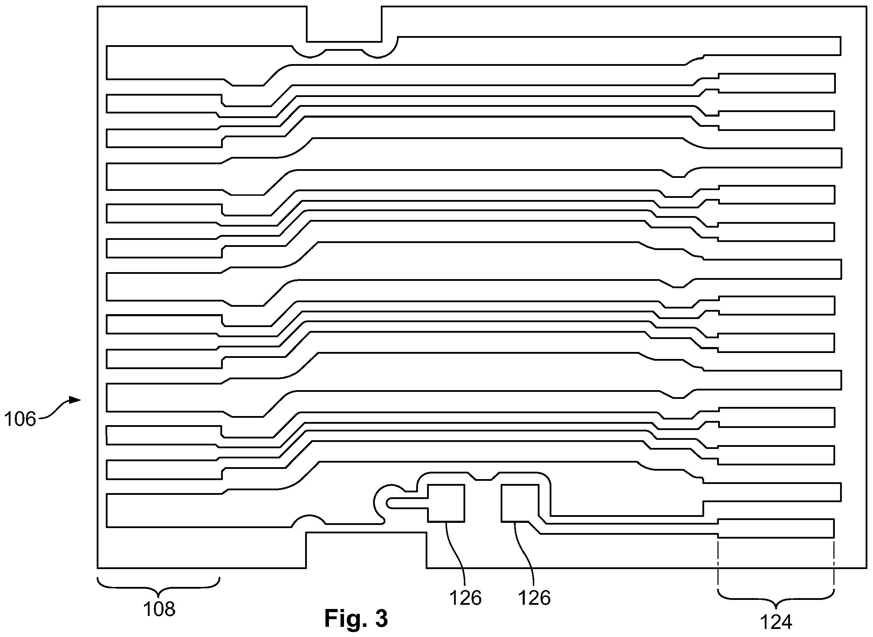

FIG. 3 shows an example of a layout of the first trace layer 106, which is present on the upper side of the cable assembly 100 of FIG. 1. As shown in FIG. 3, four pairs of traces are leading from an I/O transition interface region 108 to a contact region which is adapted to be engaged with a belonging jack connector. Each pair of signal traces is separated from the adjacent ones by means of grounded traces. If necessary, further electronic components may be soldered to this layer, such as a light emitting diode (LED) to the LED contacts 126.

The second trace layer on the opposite surface of the substrate 102 of FIG. 1 is designed in an analogous way as the one shown in FIG. 3.

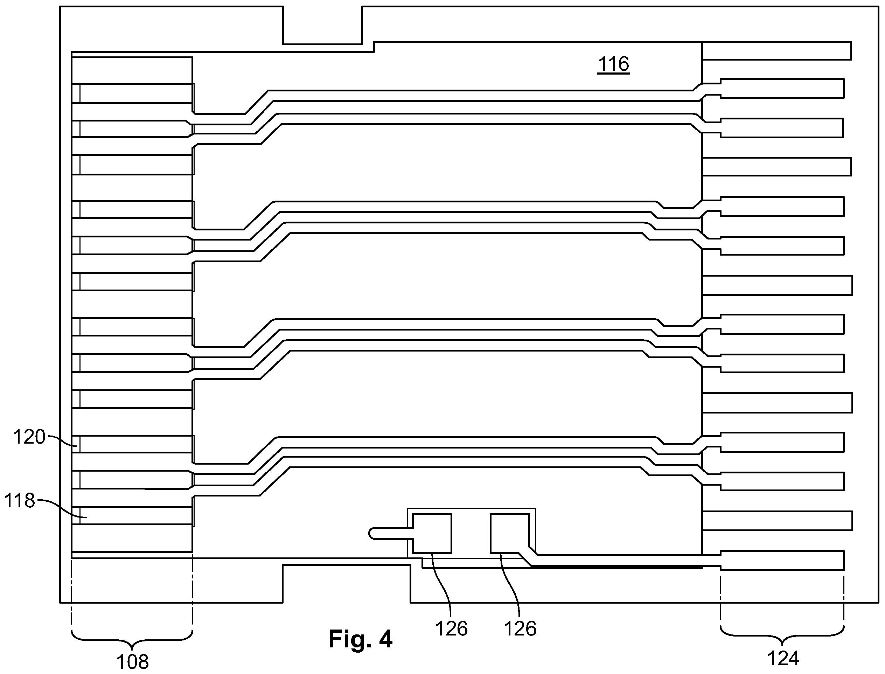

FIG. 4 illustrates schematically the location of the clearances 118 with respect to the traces 106. As may be derived from this drawing, the dimensions of the cross-talk suppression strip 118 are chosen in a way that the strip extends in the direction along the conductive leads only about 10% of the dimension of the transition interface region 108. Thus, the influence of the cross-talk suppression strip 118 on the overall impedance which is presented to the cable can be neglected and a sufficient impedance matching can be achieved.

In the IEEE 802.3ap specification no absolute cross-talk limits are given, but, acknowledging that some less lossy channels could tolerate higher cross-talk levels, a limit based on the ratio of insertion loss to the total cross talk (ICR) is defined. A fit of the actual ICR values is defined and is set against the specification

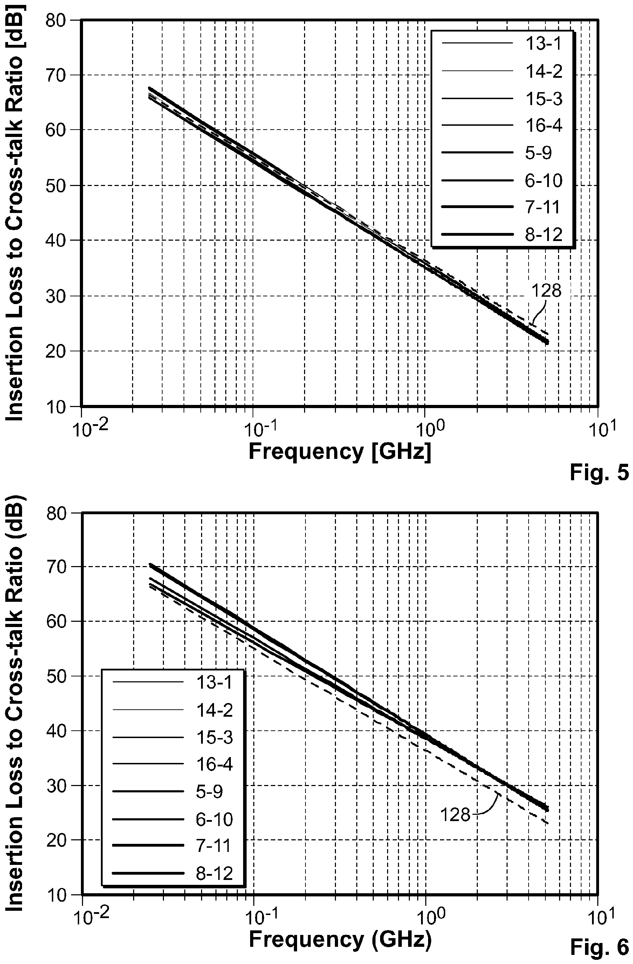

FIGs. 5 and 6 allow an assessment of the results achieved by the printed circuit board design according to the present invention in view of the ICR limit given in IEEE 802.3ap 10GBASE-KR (2008). FIG. 5 shows the case where no ground plane layer at all is present in the I/O transition interface region 108. Although the impedance matching is optimal, the cross-talk between the transmission lines and the reception lines at frequencies above 0.1 GHz are below the confidence limit for 10GBASE-KR which is shown as a broken line 128.

In contrast thereto, the insertion loss to cross-talk ratio stays always well above the confidence limit 128 according to 10GBASE-KR when using the ground plane layout according to the present invention (see FIG. 6). It could be shown that the ICR was improved by about 3dB over the total range of interest by introducing the cross-talk suppression strip according to the present invention.

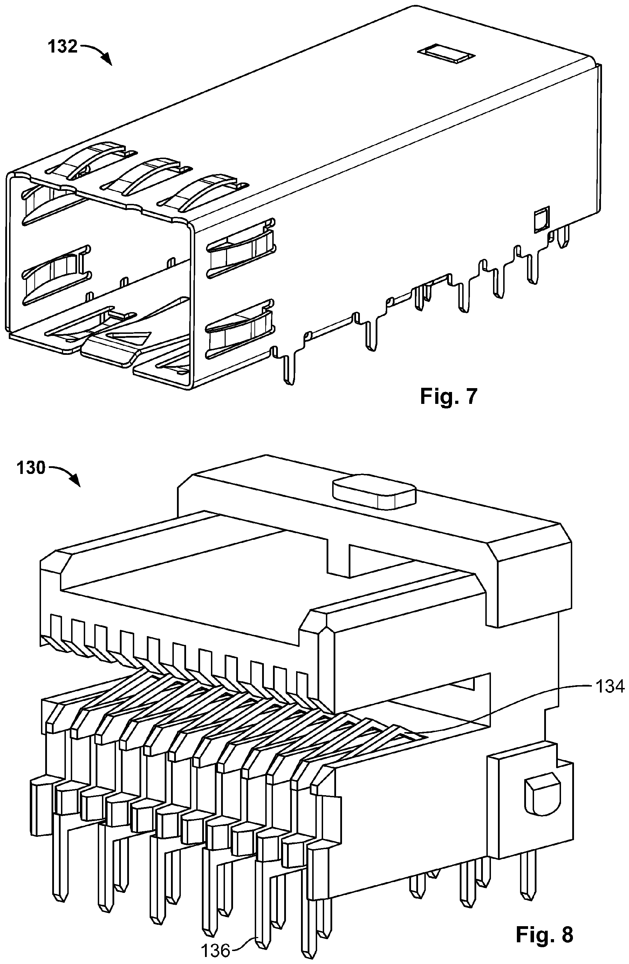

FIGs. 7 and 8 illustrate an exemplary jack connector 130 within a metal shielded housing 132, which is designed to mate with a cable assembly 100 according to the present invention. Spring contacts 134 are provided for engaging with the contact regions of the trace layer 106. These spring contacts are electrically connected to contact pins 136, which allow the mounting for instance on a printed circuit board.

The use of the terms "a" and "an" and "the" and similar referents in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Exemplary embodiments are described herein. Variations of those embodiments may become apparent to those of ordinary skill in the art upon reading the foregoing description. In particular, the grounding strip according to the present invention can also be used with a coaxial cable which is soldered to a PCB. The transmission line can be both differential line (as described) or coaxial.

**Reference Numerals**

| **Reference Numerals** | **Description** |
|---|---|
| 100 | cable assembly |
| 102 | substrate |
| 104 | cables |
| 106 | traces |
| 108 | I/O transition interface region |
| 110 | first wire |
| 112 | second wire |
| 114 | drain lead |
| 116 | ground plane layers |
| 118 | clearances |
| 120 | grounding strips |
| 122 | web |
| 124 | contact region |
| 126 | LED contacts |
| 128 | confidence limit of 10GBASE-KR |
| 130 | jack connector |
| 132 | metal housing of jack connector |
| 134 | spring contacts |
| 136 | pins of jack connector |

## Claims

1. High speed input/output, I/O, connection interface element comprising
a substrate (102) carrying a plurality of pairs of electrically conductive leads (106), each of said conductive leads having an I/O transition interface region (108) to be connected to at least one I/O conductor (104),
wherein said pairs of electrically conductive leads (106) comprise input leads and output leads which are formed in trace layers arranged on opposing faces of said substrate (102), and wherein at least one electrically conductive ground plane layer (116) is arranged at least partially within said substrate (102), being electrically insulated from said plurality of conductive leads (106),
wherein the at least one ground plane layer (116) is provided with a plurality of clearances (118),
**characterized in that**
each of said pairs of electrically conductive leads (106) is separated from an adjacent pair by a ground lead, which is formed in said trace layer and is connected to said at least one ground plane layer (116),
wherein each of said plurality of clearances (118) is separated from an adjacent one by a grounding web (122) of the at least one ground plane layer (116) and is arranged and dimensioned in a way that directly below the I/O transition interface region (108) of each pair of electrically conductive leads (106), no ground plane metallization is present, wherein said grounding web (122) is directly underlying the ground leads of the trace layer.

2. Interface element according to claim 1, wherein in an outer peripheral region of the transition interface, narrow grounding strips (120) are formed.

3. Interface element according to claim 2, wherein said grounding strips (120) in a direction along the conductive leads (106) have a dimension of less than 10 percent of the dimension of the transition interface region (108).

4. Interface element according to one of the preceding claims, wherein the impedance of each conductive lead (106) is adjusted to match the characteristic impedance of a cable (104) to be soldered to said transition interface.

5. Interface element according to one of the preceding claims, wherein said substrate (102) comprises a multilayer printed circuit board, PCB.

6. Interface element according to claim 5, wherein said at least one ground plane layer (116) is formed by a structured copper layer within said PCB.

7. Cable assembly (100) comprising at least one cable (104) including a pair of wires, a housing and an interface element according to one of the claims 1 to 6.

8. Cable assembly according to claim 7, wherein said cable (104) is mechanically secured to said interface element by means of a strain relief overmold.

9. Interconnection system comprising
a plurality of input and output cables (104),
an interface element according to one of the claims 1 to 6 connected to said cables,
a jack connector (130) adapted to be detachably connected to contact regions (124) provided at said interface element.

10. Interconnection system according to claim 9, wherein said jack connector (130) comprises spring contact elements (134) for engaging with said contact regions (124).

11. Interconnection system according to claim 9 or 10, wherein each cable (104) comprises a pair of lines (110, 112) for carrying differential signals representing one input or output signal and a shielding (114) which is connected to ground.

## Patentansprüche

1. Hochgeschwindigkeits-Eingangs/Ausgangs-, E/A, Verbindungsschnittstellenelement (100), umfassend
ein Substrat (102), das eine Vielzahl von Paaren von elektrisch leitfähigen Leitungen (106) trägt, wobei jede der leitfähigen Leitungen eine E/A-Übergangsschnittstellenregion (108) zur Verbindung mit mindestens einem E/A-Leiter (104) aufweist,
wobei die Paare von elektrisch leitfähigen Leitungen (106) Eingangsleitungen und Ausgangsleitungen umfassen, die in Leiterbahnschichten auf entgegengesetzten Flächen des Substrats (102) angeordnet sind, und wobei mindestens eine elektrisch leitfähige Masseplattenschicht (116) zumindest zum Teil in dem Substrat (102) angeordnet und elektrisch von der Vielzahl von leitfähigen Leitungen (106) isoliert ist,
wobei die mindestens eine Masseplattenschicht (116) mit eine Vielzahl von Spalten (118) versehen ist,
**dadurch gekennzeichnet, dass**
jedes der Paare von elektrisch leitfähigen Leitungen (106) von einem benachbarten Paar durch eine Masseleitung getrennt ist, die in der Leiterbahnschicht ausgebildet und mit der mindestens einen Masseplattenschicht (116) verbunden ist,
wobei jeder der Vielzahl von Spalten (118) von einem benachbarten Spalt durch ein Erdungsnetz (122) der mindestens einen Masseplattenschicht (116) getrennt und so angeordnet und dimensioniert ist, dass direkt unterhalb der E/A-Übergangsschnittstellenregion (108) der einzelnen Paare von elektrisch leitfähigen Leitungen (106) keine Masseplatten-Metallisierung vorhanden ist, wobei das Erdungsnetz direkt unterhalb der Masseleitungen der Leiterbahnschicht liegt.

2. Schnittstellenelement nach Anspruch 1, wobei in einer Außenumfangsrandregion der Übergangsschnittstelle schmale Erdungsbänder (120) ausgebildet sind.

3. Schnittstellenelement nach Anspruch 2, wobei die Erdungsbänder (120) in einer Richtung entlang der leitfähigen Leitungen (106) eine Dimension von weniger als 10 Prozent der Dimension der Übergangsschnittstellenregionen (108) aufweisen.

4. Schnittstellenelement nach einem der vorhergehenden Ansprüche, wobei die Impedanz der jeweiligen leitfähigen Leitungen (106) so angepasst wird, dass sie der charakteristischen Impedanz eines Kabels (104) entsprechen, das an die Übergangsschnittstelle gelötet wird.

5. Schnittstellenelement nach einem der vorhergehenden Ansprüche, wobei das Substrat (102) eine mehrlagige Leiterplatte, PCB, umfasst.

6. Schnittstellenelement nach Anspruch 5, wobei die mindestens eine Masseplattenschicht (116) durch eine strukturierte Kupferschicht in der PCB gebildet wird.

7. Kabelanordnung (100), umfassend mindestens ein Kabel (104), welches ein Paar von Drähten, ein Gehäuse und ein Schnittstellenelement (100) nach einem der Ansprüche 1 bis 6 beinhaltet.

8. Kabelanordnung nach Anspruch 7, wobei das Kabel (104) mithilfe eines Zugentlastungsmantels mechanisch an dem Schnittstellenelement (100) befestigt ist.

9. Verbindungssystem, umfassend
eine Vielzahl von Eingangs- und Ausgangskabeln (104),
ein Schnittstellenelement nach einem der Ansprüche 1 bis 6, das mit den Kabeln verbunden ist,
eine Anschlussbuchse (130), die dazu eingerichtet ist, lösbar mit Kontaktregionen (124) verbunden zu werden, die an dem Schnittstellenelement vorgesehen sind.

10. Verbindungssystem nach Anspruch 9, wobei die Anschlussbuchse (130) Federkontakt-elemente (134) für den Eingriff mit den Kontaktregionen (124) umfasst.

11. Verbindungssystem nach Anspruch 9 oder 10, wobei jedes Kabel (104) ein Paar von Leitungen (110, 112) zum Führen von Differentialsignalen umfasst, die ein Eingangs-oder Ausgangssignal repräsentieren, und eine Abschirmung (114), die mit der Masse verbunden ist.

## Revendications

1. Élément d'interface de connexion d'entrée/sortie (E/S) à haute vitesse, comprenant
un substrat (102) portant une pluralité de paires de broches de raccordement électriquement conductrices (106), chacune desdites broches de raccordement conductrices ayant une région d'interface de transition d'E/S (108) à connecter à au moins un conducteur d'E/S (104),
dans lequel lesdites paires de broches de raccordement électriquement conductrices (106) comprennent des broches de raccordement d'entrée et des broches de raccordement de sortie qui sont formées dans des couches à rubans disposées sur des faces opposées dudit substrat (102), et dans lequel au moins une couche électriquement conductrice de plan relié à la terre (116) est disposée au moins partiellement à l'intérieur dudit substrat (102), étant électriquement isolée de ladite pluralité de broches de raccordement conductrices (106),
dans lequel l'au moins une couche de plan relié à la terre (116) est pourvue d'une pluralité de dégagements (118),
**caractérisé en ce que**
chacune desdites paires de broches de raccordement électriquement conductrices (106) est séparée d'une paire adjacente par une broche de raccordement à la terre qui est formée dans ladite couche à rubans et est connectée à ladite au moins une couche de plan relié à la terre (116),
dans lequel chacun desdits dégagements (118) est séparé d'un dégagement adjacent par un réseau de mise à la terre (122) de l'au moins une couche de plan relié à la terre (116) et est disposé et dimensionné d'une manière telle qu'aucune métallisation du plan relié à la terre n'est présente directement en-dessous de la région d'interface de transition d'E/S (108) de chaque paire de broches de raccordement électriquement conductrices (106),
dans lequel ledit réseau de mise à la terre (122) est directement sous-jacent aux broches de raccordement à la terre de la couche à rubans.

2. Élément d'interface selon la revendication 1, dans lequel, dans une région périphérique externe de l'interface de transition, des bornes étroites de mise à la terre (120) sont formées.

3. Élément d'interface selon la revendication 2, dans lequel lesdites bornes de mise à la terre (120) dans un sens le long des broches de raccordement conductrices (106) ont une dimension inférieure à 10 pour cent de la dimension de la région d'interface de transition (108).

4. Élément d'interface selon l'une des revendications précédentes, dans lequel l'impédance de chaque broche de raccordement conductrice (106) est ajustée pour correspondre à l'impédance caractéristique d'un câble (104) à souder à ladite interface de transition.

5. Élément d'interface selon l'une des revendications précédentes, dans lequel ledit substrat (102) comprend une carte de circuit imprimé (CCI) multicouche.

6. Élément d'interface selon la revendication 5, dans lequel ladite au moins une couche de plan relié à la terre (116) est formée d'une couche de cuivre structurée à l'intérieur de ladite CCI.

7. Ensemble câble (100) comprenant au moins un câble (104) incluant une paire de fils, un logement et un élément d'interface selon l'une des revendications 1 à 6.

8. Ensemble câble selon la revendication 7, dans lequel ledit câble (104) est mécaniquement solidement fixé audit élément d'interface à l'aide d'une structure moulée de recouvrement réductrice de tension.

9. Système d'interconnexion comprenant
une pluralité de câbles (104) d'entrée et de sortie,
un élément d'interface selon l'une des revendications 1 à 6 connecté auxdits câbles,
un connecteur de type plot (130) adapté pour être connecté de manière détachable à des régions de contact (124) prévues au niveau dudit élément d'interface.

10. Système d'interconnexion selon la revendication 9, dans lequel ledit connecteur de type plot (130) comprend des pièces de contact à ressort (134) pour l'engagement avec lesdites régions de contact (124).

11. Système d'interconnexion selon la revendication 9 ou 10, dans lequel chaque câble (104) comprend une paire de lignes (110, 112) pour porter des signaux différentiels représentant un signal d'entrée ou de sortie et un blindage (114) qui est connecté à la terre.
